# EUROPEAN PATENT APPLICATION

(11) **EP 3 078 462 A1**
(43) Date of publication of application: **12.10.2016**
(21) Application number: 14868597.7
(22) Date of filing: 27.11.2014
(51) Int. Cl.: B25J 15/06, B23Q 3/08, B65G 49/06, B65G 49/07, H01L 21/677

(54) **HOLDING DEVICE, HOLDING SYSTEM, CONTROL METHOD, AND CONVEYANCE DEVICE**

(30) Priority: 03.12.2013 JP 2013250226
(71) Applicant: Harmotec Co., Ltd., Kofu City Yamanashi 400-0851 (JP)
(72) Inventor: IWASAKA, Hitoshi, Kofu City Yamanashi 400-0851 (JP); TOKUNAGA, Hideyuki, Kofu City Yamanashi 400-0851 (JP); KASAI, Yuji, Kofu City Yamanashi 400-0851 (JP); KOSHIISHI, Katsuhiro, Kofu City Yamanashi 400-0851 (JP)
(74) Representative: Stebbing, Timothy Charles
(86) International application number: PCT/JP2014/081393
(87) International publication number: WO 2015/083615

(57) **Abstract**

Swirl flow-forming body 1 for holding a plate-like member by discharging fluid to generate a negative pressure between the swirl flow-forming body and the member includes columnar main body 11, flat end face 13 formed at the main body, that faces the member, concave part 12 formed at the end face, introduction passages 17a and 17c that discharge liquid into the concave part to from a liquid swirl flow, and introduction passages 17b and 17d that discharge gas into the concave part to from a gas swirl flow.

## Description

### Technical Field

The present invention relates to holding equipment, a holding system, a control method, and conveyance equipment.

### Background Art

In recent years, equipment for conveying a plate-like member such as a semiconductor wafer or a glass substrate in a non-contact manner has been developed. For example, in Patent Document 1, equipment is proposed for conveying a plate-like member in a non-contact manner, by applying Bernoulli's principle. The equipment includes a cylindrical chamber that opens on the underside of the equipment, into which fluid is supplied to generate a swirl flow. The swirl flow generates a negative pressure in the center, which exerts suction on the plate-like member. On the other hand, a fluid flowing out of the cylindrical chamber causes a given distance to be maintained between the equipment and the plate-like member. Consequently, the equipment conveys the plate-like member in a non-contact manner. In addition, in Patent Document 1, use of liquid as fluid is proposed.

### Prior Art Document

### Patent Document

Patent Document 1: JP 2005-51260 A1

### Summary of the Invention

### Problems to be solved by the Invention

It is an object of the present invention to enable equipment for holding a subject by discharging fluid to generate a negative pressure between the equipment and the subject, to use both gas and liquid as fluid.

### Means for Solving the Problems

The present invention provides holding equipment for holding a plate-like member by discharging fluid to generate a negative pressure between the holding equipment and the member, the holding equipment comprising: a columnar main body; a flat end face formed at the main body, that faces the member; a concave part formed at the end face; a gas flow-forming means that forms a gas swirl flow in the concave part or discharges gas into the concave part to form a radial flow; and one or more liquid passages that discharge liquid into the concave part to form a liquid swirl flow or a liquid radial flow.

In the above holding equipment, the gas flow-forming means may comprise one or more gas passages that discharge gas into the concave part to form a gas swirl flow or a gas radial flow.

In the above holding equipment, the one or more liquid passages may form the liquid swirl flow or the liquid radial flow while the gas flow-forming means forms the gas swirl flow or the gas radial flow.

The present invention also provides a conveyance system comprising: holding equipment for holding a plate-like member by discharging fluid to generate a negative pressure between the holding equipment and the member, the holding equipment comprising: a columnar main body, a flat end face formed at the main body, that faces the member, a concave part formed at the end face, and a fluid flow-forming means that forms a fluid swirl flow in the concave part or discharges fluid into the concave part to form a radial flow; and a fluid switching means connected to the holding equipment, that switches fluid to be supplied to the holding equipment between gas and liquid.

The present invention also provides a control method for controlling a holding system, the holding system comprising: holding equipment for holding a plate-like member by discharging fluid to generate a negative pressure between the holding equipment and the member, the holding equipment comprising: a columnar main body, a flat end face formed at the main body, that faces the member, a concave part formed at the end face, and a fluid flow-forming means that forms a fluid swirl flow in the concave part or discharges fluid into the concave part to form a radial flow; a fluid switching means connected to the holding equipment, that switches fluid to be supplied to the holding equipment between gas and liquid; and a control means connected to the fluid switching means, that controls the fluid switching means, the method comprising: controlling, by the control means, the fluid switching means to supply gas to the holding equipment; and controlling, by the control means, the fluid switching means to supply liquid to the holding equipment.

The present invention also provides conveyance equipment comprising: first holding equipment for holding a plate-like member by discharging gas to generate a negative pressure between the first holding equipment and the member, the first holding equipment comprising: a columnar first main body, a flat first end face formed at the first main body, that faces the member, a first concave part formed at the first end face, and a fluid flow-forming means that forms a gas swirl flow in the first concave part or discharges gas into the first concave part to form a radial flow; and second holding equipment for holding the member by discharging liquid to generate a negative pressure between the second holding equipment and the member, the second holding equipment comprising: a columnar second main body, a flat second end face formed at the second main body, that faces the member, a second concave part formed at the second end face, and one or more liquid passages that discharge liquid into the second concave part to form a liquid swirl flow or a liquid radial flow.

In the above conveyance equipment, the gas flow-forming means may comprise one or more gas passages that discharge gas into the first concave part to form a gas swirl flow or a gas radial flow.

In the above conveyance equipment, the one or more liquid passages may form the liquid swirl flow or the liquid radial flow while the gas flow-forming means forms the gas swirl flow or the gas radial flow.

### Effects of the Invention

The present invention enables equipment for holding a subject by discharging fluid to generate a negative pressure between the equipment and the subject, to use both gas and liquid as fluid.

### Brief Description of the Drawings

Fig. 1 is a perspective view of an example of swirl flow-forming body 1.
Fig. 2 is a cross-sectional view of swirl flow-forming body 1 along the line A-A of Fig. 1.
Fig. 3 is a cross-sectional view of swirl flow-forming body 1 along the line B-B of Fig. 1.
Fig. 4 is a diagram showing a circuit configuration of conveyance system 100 including swirl flow-forming body 1.
Fig. 5 is a perspective view of an example of swirl flow-forming body 5.
Fig. 6 is a cross-sectional view of swirl flow-forming body 5 along the line C-C of Fig. 5.
Fig. 7 is a cross-sectional view of swirl flow-forming body 5 along the line D-D of Fig. 5.
Fig. 8 is a diagram showing a circuit configuration of conveyance system 200 including swirl flow-forming body 5.
Fig. 9 is a diagram showing an example of a configuration of conveyance equipment 10.
Fig. 10 is a diagram showing an example of a configuration of conveyance equipment 20.
Fig. 11 is a perspective view of an example of radial flow-forming body 6.
Fig. 12 is a bottom view of radial flow-forming body 6.
Fig. 13 is a cross-sectional view of radial flow-forming body 6 along the line E-E of Fig. 11.
Fig. 14 is a bottom view of an example of swirl flow-forming body 1A.
Fig. 15 is a cross-sectional view of swirl flow-forming body 1A along the line F-F of Fig. 14.

### Description of Reference Numerals

1 ··· Swirl flow-forming body, 3 ··· Liquid supply pump, 4 ··· Gas supply pump, 5 ··· Swirl flow-forming body, 6 ··· Radial flow-forming body, 7 ··· Microcomputer, 10 ··· Conveyance equipment, 11 ··· Main body, 12 ··· Concave part, 13 ··· End face, 14 ··· Jetting port, 15 ··· Slope, 16 ··· Introduction port, 17 ··· Introduction passage, 18 ··· Projecting part, 20 ··· Conveyance equipment, 51 ··· Main body, 52 ··· Concave part, 53 ··· End face, 54 ··· Jetting port, 55 ··· Slope, 56 ··· Supply port, 57 ··· Annular passage, 58 ··· Communication passage, 59 ··· Supply passage, 61 ··· Main body, 62 ··· Annular concave part, 63 ··· End face, 64 ··· Opposed face, 65 ··· Slope, 66 ··· Nozzle hole, 67 ··· Introduction port, 68 ··· Introduction passage, 69 ··· Annular passage, 70 ··· Communication passage, 100 ··· Conveyance system, 101 ··· Base body, 102 ··· Friction member, 103 ··· Hole part, 200 ··· Conveyance system, 201 ··· Base body, 2011 ··· Holding part, 2012 ··· Arm part

### Modes for Implementing the Invention

Embodiments of the present invention will be described below with reference to the drawings.

### 1. First Embodiment

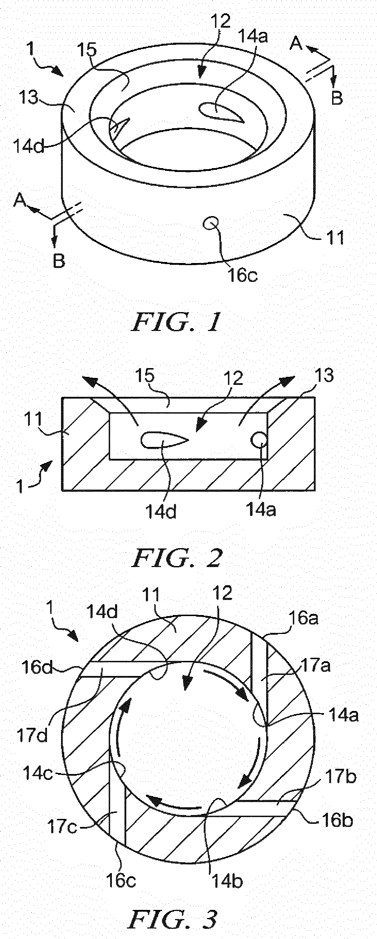

Fig. 1 is a perspective view of an example of swirl flow-forming body 1 according to a first embodiment of the present invention. Fig. 2 is a cross-sectional view of swirl flow-forming body 1 along the line A-A of Fig. 1. Fig. 3 is a cross-sectional view of swirl flow-forming body 1 along the line B-B of Fig. 1. Swirl flow-forming body 1 is equipment for holding and conveying plate-like member W such as a semiconductor wafer or a glass substrate. Swirl flow-forming body 1 holds plate-like member W by discharging fluid to generate a negative pressure between the swirl flow-forming body and the plate-like member. The fluid herein refers to gas such as compressed air, or liquid such as pure water or carbonated water. Swirl flow-forming body 1 is made of, for example, an aluminum alloy. Swirl flow-forming body 1 is an example of "holding equipment" according to the present invention.

Swirl flow-forming body 1 includes main body 11, concave part 12, end face 13, four jetting ports 14a, 14b, 14c, and 14d, and slope 15, four introduction ports 16a, 16b, 16c, and 16d, and four introduction passages 17a, 17b, 17c, and 17d, as shown in Figs. 1 to 3. Four jetting ports 14a, 14b, 14c, and 14d will hereinafter collectively be referred to as "jetting port 14." Four introduction ports 16a, 16b, 16c, and 16d will hereinafter collectively be referred to as "introduction port 16." Four introduction passages 17a, 17b, 17c, and 17d will hereinafter collectively be referred to as "introduction passage 17."

Main body 11 has a column shape. At a face of main body 11, flat end face 13 is formed. The face of main body 11 is, specifically, a face opposite to plate-like member W being conveyed. The face of main body 11 will hereinafter be referred to as "bottom face." Concave part 12 has a column shape, which is provided at end face 13. Concave part 12 is formed so that the concave part and main body 11 are coaxial.

Four jetting ports 14 have a circular shape, which are formed at the inner periphery of main body 11, which faces concave part 12. Four jetting ports 14 are arranged at the central part in an axial direction of the inner periphery at equal intervals. Jetting ports 14a and 14c are arranged so that they are opposed to each other. Specifically, jetting ports 14a and 14c are arranged so that they are symmetric with respect to the central axis of main body 11 or concave part 12. Jetting ports 14b and 14d are arranged so that they are opposed to each other. Specifically, jetting ports 14b and 14d are arranged so that they are symmetric with respect to the central axis of main body 11 or concave part 12. Fluid supplied to swirl flow-forming body 1 is discharged into concave part 12 via jetting ports 14. Liquid is discharged from jetting ports 14a and 14c, gas is discharged from jetting ports 14b and 14d.

Slope 15 is formed at the opening edge of concave part 12. Four introduction ports 16 have a circular shape, which are formed at the outer periphery of main body 11. Among four introduction ports 16, introduction ports 16a and 16c are connected to liquid supply pump 3 (described later) via, for example, a tube so that the introduction ports supply liquid into main body 11. Introduction ports 16b and 16d are connected to gas supply pump 4 (described later) via, for example, a tube so that the introduction ports supply gas into main body 11.

Four introduction passages 17 are formed substantially in parallel with end face 13. Four introduction passages 17 are also formed so that they extend in a direction tangential to the outer circumference of concave part 12. Each of introduction passages 17 connects jetting port 14 to introduction port 16. Specifically, introduction passage 17a connects jetting port 14a to introduction port 16a, introduction passage 17b connects jetting port 14b to introduction port 16b, introduction passage 17c connects jetting port 14c to introduction port 16c, and introduction passage 17d connects jetting port 14d to introduction port 16d.

Introduction passages 17a and 17c extend in parallel with each other, and discharge liquid into concave part 12 to form a swirl flow therein. Introduction passages 17b and 17d extend in parallel with each other, and form a gas swirl flow. Specifically, introduction passages 17b and 17d discharge gas into concave part 12 to form a gas swirl flow. Introduction passages 17a and 17c are an example of a "liquid passage" according to the present invention. Introduction passages 17b and 17d are an example of a "gas flow-forming means" and a "gas passage" according to the present invention.

When fluid is supplied to swirl flow-forming body 1 described in the foregoing, via introduction port 16, the fluid passes through introduction passage 17 to be discharged into concave part 12 via jetting port 14. The fluid discharged into concave part 12 forms a swirl flow and is straightened in the concave part, and thereafter flows out from the opening of the concave part. In that situation, if plate-like member W is positioned opposite end face 13, flow of outside fluid (for example, air or water) into concave part 12 is restricted. In addition, since a centrifugal force of the swirl flow develops, and entrainment occurs, fluid molecules per unit volume in the center of the swirl flow become less dense; namely, a negative pressure is generated. As a result, plate-like member W is pushed toward end face 13 by surrounding fluid. On the other hand, as plate-like member W comes close to end face 13, an amount of liquid flowing out of concave part 12 decreases, and a velocity of a fluid discharged into concave part 12 through jetting port 14 decreases, so that a pressure in the center of the swirl flow increases. Accordingly, plate-like member W does not come into contact with end face 13, and a given distance is maintained between the plate-like member and the end face.

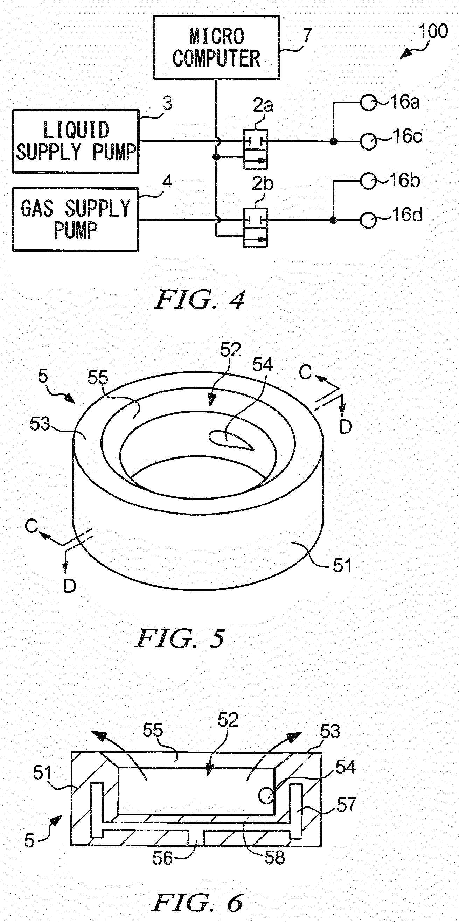

Fig. 4 is a diagram showing a circuit configuration of conveyance system 100 including swirl flow-forming body 1. As shown in Fig. 4, introduction ports 16a and 16c of swirl flow-forming body 1 are connected to liquid supply pump 3 by, for example, a tube through solenoid valve 2a. On the other hand, introduction ports 16b and 16d are connected to gas supply pump 4 by, for example, a tube through solenoid valve 2b. Solenoid valves 2a and 2b are connected to microcomputer 7. Solenoid valve 2a allows or blocks passage of liquid supplied from liquid supply pump 3, according to an on/off control signal output from microcomputer 7. On the other hand, solenoid valve 2b allows or blocks passage of gas supplied from gas supply pump 4, according to an on/off control signal output from microcomputer 7. Microcomputer 7 outputs an on/off control signal to solenoid valves 2a and 2b according to a predetermined program.

In conveyance system 100, if microcomputer 7 outputs an on control signal to solenoid valve 2a, and outputs an off control signal to solenoid valve 2b, liquid is supplied to only introduction ports 16a and 16b. As a result, a liquid swirl flow is formed in concave part 12 of swirl flow-forming body 1. On the other hand, if microcomputer 7 outputs an off control signal to solenoid valve 2a, and outputs an on control signal to solenoid valve 2b, gas is supplied to only introduction ports 16b and 16d. As a result, a gas swirl flow is formed in concave part 12 of swirl flow-forming body 1. In essence, conveyance system 100 according to the present embodiment is able to use liquid and gas selectively. For example, conveyance system 100 may use liquid when swirl flow-forming body 1 conveys plate-like member W in a liquid, and may use gas when swirl flow-forming body 1 conveys plate-like member W in gas.

It is to be noted that if microcomputer 7 outputs an on control signal to both solenoid valves 2a and 2b, liquid is supplied to introduction ports 16a and 16b, and gas is supplied to introduction ports 16b and 16d. As a result, a swirl flow of mixed fluid consisting of liquid and gas is formed in concave part 12 of swirl flow-forming body 1. In that situation, introduction passages 17b and 17d form a liquid swirl flow while introduction passages 17a and 17c form a gas swirl flow.

### 2. Second Embodiment

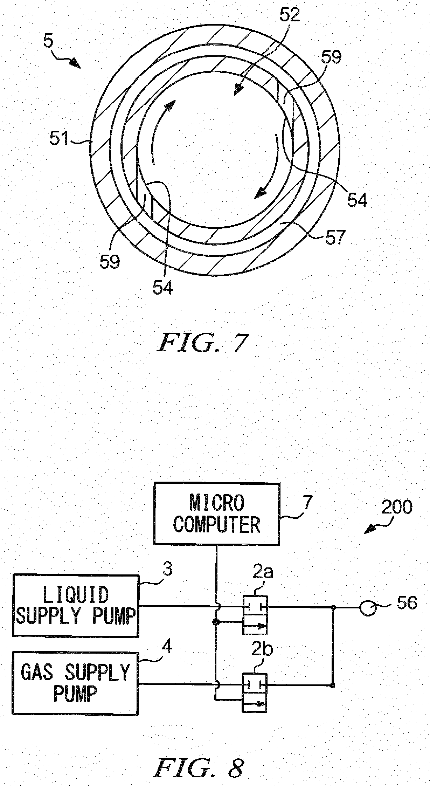

Fig. 5 is a perspective view of an example of swirl flow-forming body 5 according to a second embodiment of the present invention. Fig. 6 is a cross-sectional view of swirl flow-forming body 5 along the line C-C of Fig. 5. Fig. 7 is a cross-sectional view of swirl flow-forming body 5 along the line D-D of Fig. 5. Swirl flow-forming body 5 is equipment for holding and conveying plate-like member W such as a semiconductor wafer or a glass substrate. Swirl flow-forming body 5 holds plate-like member W by discharging fluid to generate a negative pressure between the swirl flow-forming body and the plate-like member. The fluid herein refers to gas such as compressed air, or liquid such as pure water or carbonated water. Swirl flow-forming body 5 is made of, for example, an aluminum alloy. Swirl flow-forming body 5 is an example of "holding equipment" according to the present invention.

Swirl flow-forming body 5 includes main body 51, concave part 52, end face 53, two jetting ports 54, and slope 55, as shown in Figs. 5 to 7. Main body 51 has a column shape. At a face of main body 51, flat end face 53 is formed. The face of main body 51 is, specifically, a face opposite to plate-like member W being conveyed. The face of main body 51 will hereinafter be referred to as "bottom face." Concave part 52 has a column shape, which is provided at end face 53. Concave part 52 is formed so that the concave part and main body 51 are coaxial.

Two jetting ports 54 are formed at the inner periphery of main body 51, which faces concave part 52. Two jetting ports 54 are arranged at the central part in an axial direction of the inner periphery. Two jetting ports 54 are arranged so that they are opposed to each other. Specifically, jetting ports 54 are arranged so that they are symmetric with respect to the central axis of main body 51 or concave part 52. Fluid supplied to swirl flow-forming body 5 is discharged into concave part 52 via jetting ports 54. Slope 55 is formed at the opening edge of concave part 52.

Swirl flow-forming body 5 also includes supply port 56, annular passage 57, communication passage 58, and two supply passages 59, as shown in Figs. 6 and 7. Supply port 56 has a circular shape, which is provided at the center of an upper face (namely, a face opposite to the bottom face) of main body 51. Supply port 56 is connected to liquid supply pump 3 and gas supply pump 4 via, for example, tubes so that the supply port supplies fluid into main body 51. Annular passage 57 has a cylindrical shape, which is formed inside main body 51 so that the annular passage surrounds concave part 52. Annular passage 57 is formed so that the annular passage and concave part 52 are coaxial. Annular passage 57 supplies fluid supplied from communication passage 58, to supply passage 59. Communication passage 58 is provided inside main body 51, and extends linearly in a radial direction of the bottom or upper face of the main body.

Both ends of communication passage 58 communicate with annular passage 57. Communication passage 58 supplies fluid supplied into main body 51 via supply port 56, to annular passage 57. Two supply passages 59 are formed substantially in parallel with end face 53. Two supply passages 59 are also formed so that they extend in a direction tangential to the outer circumference of concave part 52. Two supply passages 59 extend in parallel with each other. One end of each of supply passages 59 communicates with annular passage 57, and the other end communicates with jetting port 54. Supply passages 59 form a fluid swirl flow in concave part 52. Supply passages 59 are an example of a "fluid flow-forming means" according to the present invention.

When fluid is supplied to swirl flow-forming body 5 described in the foregoing, via supply port 56, the fluid passes through communication passage 58, annular passage 57, and supply passage 59 to be discharged into concave part 52 via jetting port 54. The fluid discharged into concave part 52 forms a swirl flow and is straightened in the concave part, and thereafter flows out from the opening of the concave part. In that situation, if plate-like member W is positioned opposite end face 53, flow of outside fluid (for example, air or water) into concave part 52 is restricted. In addition, since a centrifugal force of the swirl flow develops, and entrainment occurs, fluid molecules per unit volume in the center of the swirl flow become less dense; namely, a negative pressure is generated between swirl flow-forming body 5 and plate-like member W. As a result, plate-like member W is pushed toward end face 53 by surrounding fluid. On the other hand, as plate-like member W comes close to end face 53, an amount of fluid flowing out of concave part 52 decreases, and a velocity of a fluid discharged into concave part 52 through jetting port 54 decreases, whereby a pressure in the center of the swirl flow increases. Accordingly, plate-like member W does not come into contact with end face 53, and a given distance is maintained between the plate-like member and the end face.

Fig. 8 is a diagram showing a circuit configuration of conveyance system 200 including swirl flow-forming body 5. Conveyance system 200 is an example of a "holding system" according to the present invention. As shown in Fig. 8, supply port 56 of swirl flow-forming body 5 is connected to liquid supply pump 3 by, for example, a tube through solenoid valve 2a, and is connected to gas supply pump 4 by, for example, a tube through solenoid valve 2b. Solenoid valves 2a and 2b are connected to microcomputer 7.

Solenoid valve 2a allows or blocks passage of liquid supplied from liquid supply pump 3, according to an on/off control signal output from microcomputer 7. On the other hand, solenoid valve 2b allows or blocks passage of gas supplied from gas supply pump 4, according to an on/off control signal output from microcomputer 7. Solenoid valves 2a and 2b have a function of switching fluid to be supplied to swirl flow-forming body 5 between gas and liquid. Solenoid valves 2a and 2b are an example of a "fluid switching means" according to the present invention. Microcomputer 7 outputs an on/off control signal to solenoid valves 2a and 2b according to a predetermined program. Microcomputer 7 is an example of a "control means" according to the present invention.

In conveyance system 200, if microcomputer 7 outputs an on control signal to solenoid valve 2a, and outputs an off control signal to solenoid valve 2b, liquid is supplied to supply port 56 of swirl flow-forming body 5. As a result, a liquid swirl flow is formed in concave part 52 of swirl flow-forming body 5. On the other hand, if microcomputer 7 outputs an off control signal to solenoid valve 2a, and outputs an on control signal to solenoid valve 2b, gas is supplied to supply port 56 of swirl flow-forming body 5. As a result, a gas swirl flow is formed in concave part 52 of swirl flow-forming body 5. In essence, conveyance system 200 according to the present embodiment is able to use liquid and gas selectively. For example, conveyance system 200 may use liquid when swirl flow-forming body 5 conveys plate-like member W in a liquid, and may use gas when swirl flow-forming body 5 conveys plate-like member W in gas.

### 3. Modifications

The above embodiments may be modified as described below. Two or more of the following modifications may be combined with each other.

### 3-1. Modification 1

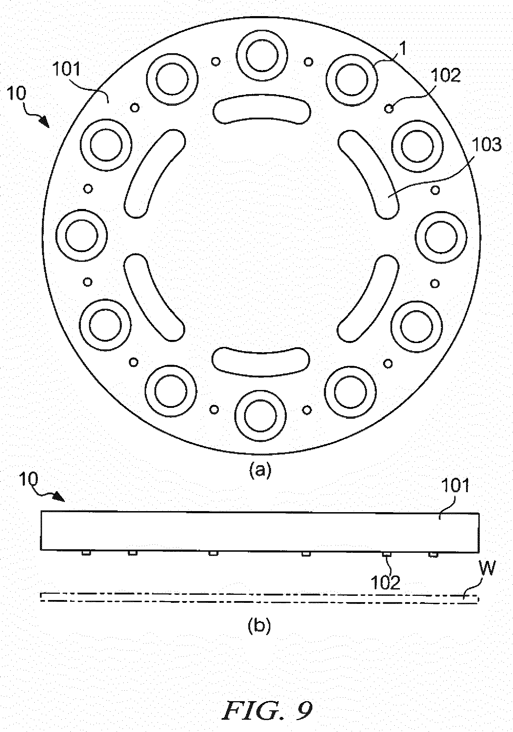

A plurality of swirl flow-forming bodies 1 according to the first embodiment may be fixed to a plate-like frame depending on a size of plate-like member W to be conveyed. Fig. 9 is a diagram showing an example of a configuration of conveyance equipment 10 according to the present modification. Specifically, Fig. 9(a) is a bottom view of conveyance equipment 10, and Fig. 9(b) is a side view of conveyance equipment 10. Conveyance equipment 10 includes base body 101, twelve swirl flow-forming bodies 1, twelve friction members 102, and six hole parts 103, as shown in Fig. 9.

Base body 101 has a disk shape. Base body 101 is made of, for example, an aluminum alloy. Twelve swirl flow-forming bodies 1 are provided at a face of base body 101, which face, specifically, a face opposite to plate-like member W being conveyed. The face of base body 101 will hereinafter be referred to as "bottom face." Twelve swirl flow-forming bodies 1 are arranged at the bottom face on the circumference of a circle. Twelve swirl flow-forming bodies 1 are arranged at equal intervals along the outer circumference of base body 101.

Each of twelve friction members 102 has a column shape, which is provided at the bottom face of base body 101. Twelve friction members 102 are arranged at the bottom face at equal intervals on the circumference of the circle, on which swirl flow-forming bodies 1 are arranged. Each of friction members 102 is arranged between two swirl flow-forming bodies 1. Each of friction members 102 is a member for generating a friction force between the friction member and a surface of plate-like member W being conveyed, by coming into contact with the surface of the plate-like member, which friction force prevents the plate-like member from moving. Each of friction members 102 is made of, for example, a fluorine-contained rubber. Six hole parts 103 are through-holes having an elongated shape with rounded ends, which are provided at base body 101. Six hole parts 103 are arranged at base body 101 at equal intervals on the circumference of a circle. The circle on whose circumference hole parts 103 are arranged and the circle on whose circumference swirl flow-forming bodies 1 are arranged are concentric. Hole parts 103 are arranged nearer the center of a surface of base body 101 in relation to swirl flow-forming bodies 1.

When the present modification is employed, each of swirl flow-forming bodies 1 fixed to conveyance equipment 10 may be connected to only one of liquid supply pump 3 and gas supply pump 4. Swirl flow-forming bodies 1 connected to liquid supply pump 3 and swirl flow-forming bodies 1 connected to gas supply pump 4 may be alternately arranged in conveyance equipment 10. For example, when conveyance equipment 10 conveys plate-like member W in a liquid, only swirl flow-forming bodies 1 connected to liquid supply pump 3 may be supplied with liquid, and when conveyance equipment 10 conveys plate-like member W in gas, only swirl flow-forming bodies 1 connected to gas supply pump 4 may be supplied with gas.

In the present modification, swirl flow-forming bodies I connected to liquid supply pump 3 are an example of "second holding equipment" according to the present invention. Introduction passages 17a and 17c provided at the swirl flow-forming bodies are an example of a "liquid passage" according to the present invention. On the other hand, swirl flow-forming bodies 1 connected to gas supply pump 4 are an example of "first holding equipment" according to the present invention. Introduction passages 17b and 17d provided at the swirl flow-forming bodies are an example of a "gas flow-forming means" according to the present invention.

It is to be noted that in conveyance equipment 10, swirl flow-forming bodies 1 connected to liquid supply pump 3 may be supplied with liquid, while swirl flow-forming bodies 1 connected to gas supply pump 4 are supplied with gas. In that situation, swirl flow-forming bodies 1 (specifically, introduction passages 17a and 17c) connected to liquid supply pump 3 form a liquid swirl flow, while swirl flow-forming bodies I (specifically, introduction passages 17b and 17d) connected to gas supply pump 4 form a gas swirl flow.

It is also to be noted that conveyance equipment 10 may be provided with swirl flow-forming bodies 5 according to the second embodiment, instead of swirl flow-forming bodies 1.

### 3-2. Modification 2

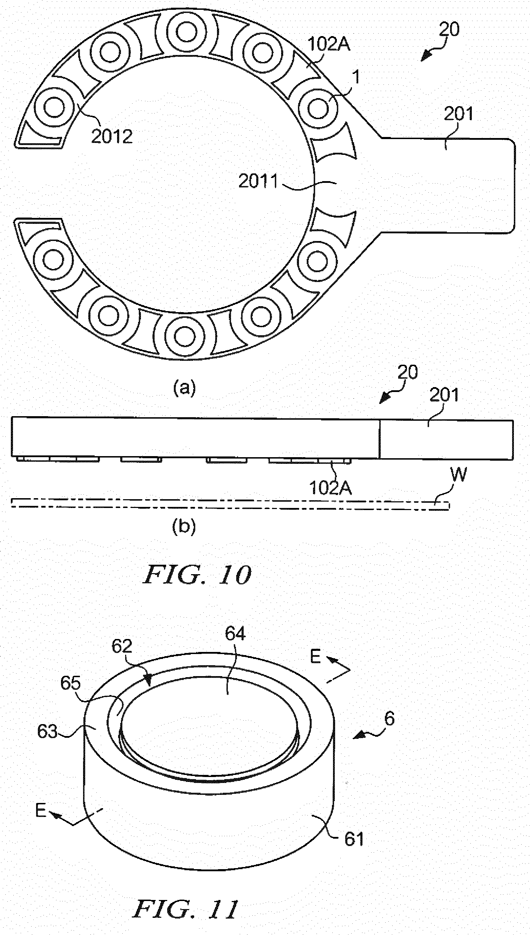

Conveyance equipment 10 according to modification 1 may have another shape. Fig. 10 is a diagram showing an example of a configuration of conveyance equipment 20 according to the present modification. Specifically, Fig. 10(a) is a bottom view of conveyance equipment 20, and Fig. 10(b) is a side view of conveyance equipment 20. Conveyance equipment 20 includes base body 201, ten swirl flow-forming bodies 1, and twelve friction members 102A, as shown in Fig. 10.

Base body 201 is a plate-like member in the shape of a two-pronged fork, which includes rectangular holding part 2011 and two arm parts 2012 that extend forkedly from the holding part. Base body 201 is made of, for example, an aluminum alloy. Ten swirl flow-forming bodies 1 are provided at a face of two arm parts 2012 constituting base body 201. The face of arm parts 2012 is, specifically, a face opposite to plate-like member W being conveyed. The face of arm parts 2012 will hereinafter be referred to as "bottom face." Ten swirl flow-forming bodies 1 are arranged at two arm parts 2012 on the circumference of a circle. Five swirl flow-forming bodies 1 are arranged at each of arm parts 2012 at equal intervals.

Each of twelve friction members 102A, which are provided at the bottom face of two arm parts 2012, is a plate-like member. Twelve friction members 102A are arranged at the bottom face on the circumference of the circle, on which swirl flow-forming bodies 1 are arranged. Friction members 102A are arranged at each of arm parts 2012 so that two friction members 102A sandwich one swirl flow-forming body 1. Each of friction members 102A generates a friction force between the friction member and a surface of plate-like member W being conveyed, by coming into contact with the surface of the plate-like member, which friction force prevents the plate-like member from moving. Each of friction members 102A is made of, for example, a fluorine-contained rubber.

### 3-3. Modification 3

In the second embodiment, swirl flow-forming body 5 that forms a swirl flow may be replaced with a radial flow-forming body that forms a radial flow. Fig. 11 is a perspective view of an example of radial flow-forming body 6 according to the present modification. Radial flow-forming body 6 is equipment for holding plate-like member W by discharging fluid to generate a negative pressure between the radial flow-forming body and the plate-like member.

Radial flow-forming body 6 includes main body 61, annular concave part 62, end face 63, opposed face 64, and slope 65, as shown in Fig. 11. Main body 61 has a column shape. At a face of main body 61, flat end face 63 is formed. The face of main body 61 is, specifically, a face opposite to plate-like member W being conveyed. The face of main body 61 will hereinafter be referred to as "bottom face." Annular concave part 62 is formed at end face 63 so that the annular concave part and the outer circumference of main body 61 are concentric. At the bottom face of main body 61, flat opposed face 64 is formed. Opposed face 64 is a face opposite plate-like member W being conveyed, which face is surrounded by annular concave part 62. Opposed face 64 is formed at the bottom face of main body 61 so that it is hollow relative to end face 63. Slope 65 is formed at the opening edge (specifically, at the outer opening edge) of annular concave part 62.

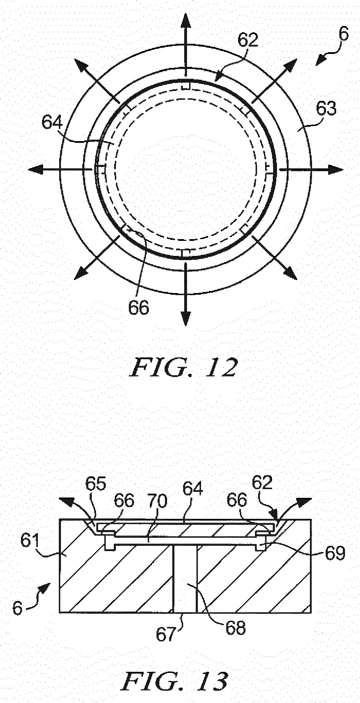

Fig. 12 is a bottom view of radial flow-forming body 6. Fig. 13 is a cross-sectional view of radial flow-forming body 6 along the line E-E of Fig. 11. As shown in Figs. 12 and 13, radial flow-forming body 6 further includes six nozzle holes 66, introduction port 67, introduction passage 68, annular passage 69, and communication passage 70. Introduction port 67 has a circular shape, which is provided at the center of an upper face (namely, a face opposite to the bottom face) of main body 61. Introduction port 67 is connected to liquid supply pump 3 and gas supply pump 4, which are shown in Fig. 4, via, for example, tubes. Introduction passage 68 is provided inside main body 61, which extends linearly along the central axis of main body 61. One end of introduction passage 68 communicates with introduction port 67, and the other end communicates with communication passage 70. Introduction passage 68 supplies liquid supplied into main body 61 via introduction port 67, to communication passage 70.

Communication passage 70 is provided inside main body 61, which extends linearly in a radial direction of annular passage 69. The central part in an axial direction of communication passage 70 communicates with introduction passage 68, and both ends communicate with annular passage 69. Communication passage 70 supplies fluid supplied from introduction passage 68, to annular passage 69. Annular passage 69 has a cylindrical shape, which is provided inside main body 61. Annular passage 69 is formed so that the annular passage and main body 61 are coaxial. Annular passage 69 supplies fluid supplied from communication passage 70, to nozzle holes 66.

Nozzle holes 66 are formed substantially in parallel with end face 63 or opposed face 64. Nozzle holes 66 are also formed so that they extend linearly in a radial direction of the bottom or upper face of main body 61. One end of nozzle hole 66 communicates with annular passage 69, and the other end communicates with annular concave part 62. Six nozzle holes 66 are formed on the same plane so that adjacent nozzle holes 66 form an angle of substantially 45 degrees. Each of six nozzle holes 66 discharges fluid such as gas into annular concave part 62 to form a radial flow therein. Nozzle holes 66 are an example of a "fluid flow-forming means" according to the present invention.

When fluid is supplied to radial flow-forming body 6 described in the foregoing, via introduction port 67, the fluid passes through introduction passage 68, communication passage 70, and annular passage 69 to be discharged into annular concave part 62 via nozzle hole 66. The fluid discharged into annular concave part 62 flows out of the opening of the annular concave part. In that situation, if plate-like member W is positioned opposite opposed face 64, flow of outside fluid (for example, air or water) into the space between the opposed face and the plate-like member is restricted. In addition, since entrainment occurs due to radial flow, fluid molecules per unit volume in the space become less dense; namely, a negative pressure is generated. As a result, plate-like member W is pushed toward end face 63 by surrounding fluid. On the other hand, as plate-like member W comes close to end face 63, an amount of fluid flowing out of annular concave part 62 decreases, and a velocity of a fluid discharged into through nozzle hole 66 decreases, whereby a pressure in the space increases. Accordingly, plate-like member W does not come into contact with end face 63, and a given distance is maintained between the plate-like member and the end face.

It is to be noted that the configuration (especially, the number of nozzle holes 66 and the configuration of the liquid passages in main body 61) of radial flow-forming body 6 is not limited to the example shown in the present modification. The configuration may be determined based on the size, shape, and material of plate-like member W to be conveyed by radial flow-forming body 6.

It is also to be noted that conveyance equipment 10 according to modification 1 may be provided with radial flow-forming bodies 6, instead of swirl flow-forming bodies 1. Each of radial flow-forming bodies 6 fixed to conveyance equipment 10 may be connected to one of liquid supply pump 3 and gas supply pump 4. Radial flow-forming bodies 6 connected to liquid supply pump 3 and radial flow-forming bodies 6 connected to gas supply pump 4 may be alternately arranged in conveyance equipment 10. In the present modification, radial flow-forming bodies 6 connected to liquid supply pump 3 are an example of "second holding equipment" according to the present invention. Nozzle holes 66 provided at the radial flow-forming bodies are an example of a "liquid passage" according to the present invention. On the other hand, radial flow-forming bodies 6 connected to gas supply pump 4 are an example of "first holding equipment" according to the present invention. Nozzle holes 66 provided at the radial flow-forming bodies are an example of a "gas flow-forming means" and a "gas passage" according to the present invention.

It is also to be noted that nozzle holes 66 of radial flow-forming body 6 may discharge different fluids, as in the case of introduction passages 17 provided at swirl flow-forming body 1 according to the first embodiment. In the modification, nozzle holes 66 that discharge gas into annular concave part 62 to form a gas radial flow therein are an example of a "gas flow-forming means" according to the present invention. On the other hand, nozzle holes 66 that discharge liquid into annular concave part 62 to form a liquid radial flow therein are an example of a "liquid passage" according to the present invention.

### 3-4. Modification 4

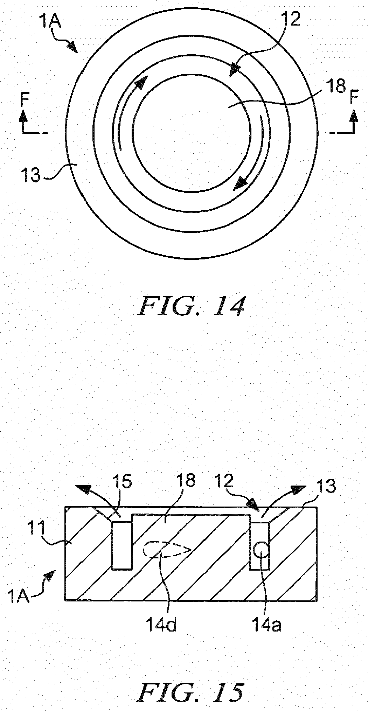

Swirl flow-forming body 1 according to the first embodiment may have another shape. Fig. 14 is a bottom view of an example of swirl flow-forming body 1A according to the present modification. Fig. 15 is a cross-sectional view of swirl flow-forming body 1A along the line F-F of Fig. 14. As shown in Figs. 14 and 15, swirl flow-forming body 1A further includes projecting part 18 as compared to swirl flow-forming body 1. Projecting part 18 has a column shape, which is formed so that the projecting part extends from the bottom of concave part 12. Projecting part 18 is also formed so that the projecting part and main body 11 (or concave part 12) are coaxial. The upper face (specifically, a face opposite to plate-like member W being conveyed) of projecting part 18 is formed so that the upper face is hollow relative to end face 13. Between the outer periphery of projecting part 18 and the inner periphery of main body 11, a fluid passage is formed, in which fluid discharged into concave part 12 flows and forms a swirl flow.

It is to be noted that the upper face of projecting part 18 and end face 13 may be on the same plane. The upper face of projecting part 18 may have a chamfered edge.

A projecting part similar to projecting part 18 may be provided at the bottom of concave part 52 of swirl flow-forming body 5 according to the second embodiment.

### 3-5. Modification 5

Swirl flow-forming body 1 according to the first embodiment may be provided with a known electric fan (see, for example, JP 2011-138948 A1), instead of introduction passages 17b and 17d. Specifically, swirl flow-forming body 1 may be provided with inlets formed at main body 11, and a fan provided inside concave part 12, that rotates to take gas into the concave part via the inlets, and generate a swirl flow in the concave part. The fan is an example of a "gas flow-forming means" according to the present invention. The fan may be caused to rotate electrically or not to rotate while introduction passage 17a and 17c discharge liquid into concave part 12 to form a liquid swirl flow therein.

A similar electric fan may be provided at swirl flow-forming body 5 according to the second embodiment. Specifically, swirl flow-forming body 5 may be provided with inlets formed at main body 51, and a fan provided inside concave part 52, that rotates to take gas into the concave part via the inlets, and generate a swirl flow in the concave part. The fan is an example of a "gas flow-forming means" according to the present invention. To form a liquid swirl flow in concave part 52 of swirl flow-forming body 5 including the electric fan, microcomputer 7 of conveyance system 200 may output an on control signal to solenoid valve 2a, and to form a gas swirl flow in the concave part, the microcomputer 7 may output an on control signal to the electric fan. The electric fan may be caused to rotate while a liquid swirl flow is formed in concave part 52.

### 3-6. Modification 6

The configuration of base body 101 of conveyance equipment 10 is not limited to the example shown in modification 1. The number, shape, and position of friction members 102 and hole parts 103, which are provided at base body 101 of conveyance equipment 10, are not limited to the example shown in modification 1. The parameters may be determined based on the size, shape, and material of plate-like member W to be conveyed by conveyance equipment 10. Friction members 102 or hole parts 103 may be omitted from base body 101 of conveyance equipment 10. In a case where friction members 102 are omitted from base body 101 of conveyance equipment 10, the base body may be provided with a known centering guide (see, for example, JP 2005-51260 A1) for positioning plate-like member W. Similarly, the configuration of base body 201 of conveyance equipment 20 is not limited to the example shown in modification 2.

### 3-7. Modification 7

The number, configuration, and position of swirl flow-forming bodies 1 provided at base body 101 of conveyance equipment 10 are not limited to the example shown in modification 1. The parameters may be determined based on the size, shape, and material of plate-like member W to be conveyed by conveyance equipment 10. For example, the number of swirl flow-forming bodies 1 may be smaller or greater than 12. Two or more lines of swirl flow-forming bodies 1 may be arranged along the outer circumference of base body 101. Similarly, the number, configuration, and position of swirl flow-forming bodies 5 provided at base body 201 of conveyance equipment 20 are not limited to the example shown in modification 2.

### 3-8. Modification 8

Main body 11 of swirl flow-forming body 1 according to the first embodiment may have a rectangular column shape or an elliptic column shape, instead of a circular column shape. The number of introduction passages 17provided at swirl flow-forming bodies 1 may be smaller or greater than four. Slope 15 may be omitted from main body 11 of swirl flow-forming body 1. In other words, the edge of end face 13 may not be chamfered. The modifications may be applied to swirl flow-forming body 5.

## Claims

1. Holding equipment for holding a plate-like member by discharging fluid to generate a negative pressure between the holding equipment and the member, the holding equipment comprising:
a columnar main body;
a flat end face formed at the main body, that faces the member;
a concave part formed at the end face;
a gas flow-forming means that forms a gas swirl flow in the concave part or discharges gas into the concave part to form a radial flow; and
one or more liquid passages that discharge liquid into the concave part to form a liquid swirl flow or a liquid radial flow.

2. The holding equipment according to Claim 1, wherein the gas flow-forming means comprises one or more gas passages that discharge gas into the concave part to form a gas swirl flow or a gas radial flow.

3. The holding equipment according to Claim 1 or 2, wherein the one or more liquid passages form the liquid swirl flow or the liquid radial flow while the gas flow-forming means forms the gas swirl flow or the gas radial flow.

4. A conveyance system comprising:
holding equipment for holding a plate-like member by discharging fluid to generate a negative pressure between the holding equipment and the member, the holding equipment comprising:
a columnar main body,
a flat end face formed at the main body, that faces the member,
a concave part formed at the end face, and
a fluid flow-forming means that forms a fluid swirl flow in the concave part or discharges fluid into the concave part to form a radial flow; and
a fluid switching means connected to the holding equipment, that switches fluid to be supplied to the holding equipment between gas and liquid.

5. A control method for controlling a holding system, the holding system comprising:
holding equipment for holding a plate-like member by discharging fluid to generate a negative pressure between the holding equipment and the member, the holding equipment comprising:
a columnar main body,
a flat end face formed at the main body, that faces the member,
a concave part formed at the end face, and
a fluid flow-forming means that forms a fluid swirl flow in the concave part or discharges fluid into the concave part to form a radial flow;
a fluid switching means connected to the holding equipment, that switches fluid to be supplied to the holding equipment between gas and liquid; and
a control means connected to the fluid switching means, that controls the fluid switching means, the method comprising:
controlling, by the control means, the fluid switching means to supply gas to the holding equipment; and
controlling, by the control means, the fluid switching means to supply liquid to the holding equipment.

6. Conveyance equipment comprising:
first holding equipment for holding a plate-like member by discharging gas to generate a negative pressure between the first holding equipment and the member, the first holding equipment comprising:
a columnar first main body,
a flat first end face formed at the first main body, that faces the member,
a first concave part formed at the first end face, and
a fluid flow-forming means that forms a gas swirl flow in the first concave part or discharges gas into the first concave part to form a radial flow;
and
second holding equipment for holding the member by discharging liquid to generate a negative pressure between the second holding equipment and the member, the second holding equipment comprising:
a columnar second main body,
a flat second end face formed at the second main body, that faces the member,
a second concave part formed at the second end face, and
one or more liquid passages that discharge liquid into the second concave part to form a liquid swirl flow or a liquid radial flow.

7. The conveyance equipment according to Claim 6, wherein the gas flow-forming means comprises one or more gas passages that discharge gas into the first concave part to form a gas swirl flow or a gas radial flow.

8. The conveyance equipment according to Claim 6 or 7, wherein the one or more liquid passages form the liquid swirl flow or the liquid radial flow while the gas flow-forming means forms the gas swirl flow or the gas radial flow.
